# EUROPÄISCHE PATENTSCHRIFT

(11) **EP 2 460 203 B1**
(45) Veröffentlichungstag und Bekanntmachung des Hinweises auf die Patenterteilung: **04.09.2019**
(21) Anmeldenummer: 10729904.2
(22) Anmeldetag: 08.07.2010
(51) Int. Cl.: H01L 51/52, H01L 51/56

(54) **ORGANISCHES BAUTEIL UND VERFAHREN ZU DESSEN HERSTELLUNG**
ORGANIC COMPONENT AND METHOD FOR THE PRODUCTION THEREOF
ÉLÉMENT ORGANIQUE ET SON PROCÉDÉ DE FABRICATION

(30) Priorität: 30.07.2009 DE 102009035392
(43) Veröffentlichungstag der Anmeldung: 06.06.2012
(73) Patentinhaber: OSRAM OLED GmbH, 93049 Regensburg (DE)
(72) Erfinder: PHILIPPENS, Marc, 93049 Regensburg (DE); SCHLENKER, Tilman, 93152 Nittendorf (DE)
(74) Vertreter: Epping - Hermann - Fischer
(86) Internationale Anmeldenummer: PCT/EP2010/059837
(87) Internationale Veröffentlichungsnummer: WO 2011/012420

(56) Entgegenhaltungen:
- EP-A2- 1 359 628
- US-A1- 2001 046 597
- US-A1- 2003 066 311
- US-A1- 2004 251 524
- US-B2- 6 736 942

## Beschreibung

Die vorliegende Erfindung betrifft ein Bauteil mit einem ersten Substrat und einem zweiten Substrat. Weiterhin betrifft die Erfindung ein Verfahren zum Herstellen eines solchen Bauteils.

Eine Vorrichtung, die zwei Substrate und eine dazwischen angeordnete organische lichtemittierende Diode (OLED) aufweist, ist beispielsweise aus der Patentschrift US 6,998,776 B2 bekannt. Dabei sind zwei Substrate mittels einer Abdichtung miteinander verbunden. Die Abdichtung ist über eine Fritte gebildet, die mittels einer Laserquelle so geheizt worden ist, dass die Fritte geschmolzen ist und so eine luftdichte Abdichtung bildet.

Das Heizen der Fritte erfolgt bei derartigen Verfahren meist lokal durch einen umlaufenden Laserstrahl. Dabei muss der Laserstrahl durch eines der beiden Substrate hindurch treten, um die Fritte erreichen zu können. Ein für den Laserstrahl nicht transparentes Substratmaterial ist somit bei derartigen Herstellungsverfahren ungeeignet. Auch in Bereichen, in denen auf einem der Substrate metallische Leiterbahnen angeordnet sind, ist ein Erreichen der Fritte mit dem Laserstrahl nicht möglich. Das Heizen der Fritte mittels eines umlaufenden Laserstrahls ist weiter für die Herstellung in Großserie zu langsam und daher im Wesentlichen ungeeignet. Ferner entsteht durch das Führen des Laserstrahls entlang der Fritte nachteilig ein hoher apparativer Aufwand.

In den Dokumenten US 2004/251524 A1, US 6,736,942 B2 und US 2001/046597 A1 werden reaktionsfähige Folien zum Verbinden von Substraten erwähnt.

Der Erfindung liegt die Aufgabe zugrunde, ein verbessertes Bauteil bereitzustellen, das ein organisches optoelektronisches Bauelement vor Umwelteinflüssen schützt und gleichzeitig eine vereinfachte Herstellung aufweist. Eine weitere Aufgabe besteht darin, ein alternatives Verfahren zur Herstellung eines solchen Bauteils anzugeben.

Diese Aufgabe wird unter anderem durch ein Bauteil mit den Merkmalen des Patentanspruchs 1 und ein Verfahren zu dessen Herstellung mit den Merkmalen des Patentanspruchs 10 gelöst. Vorteilhafte Ausführungsformen und bevorzugte Weiterbildungen eines Bauteils und des Verfahrens zu dessen Herstellung sind Gegenstand der abhängigen Ansprüche.

Bei einer Ausführungsform des Bauteils sind ein erstes Substrat und ein zweites Substrat vorgesehen, wobei auf dem ersten Substrat mindestens ein optoelektronisches Bauelement angeordnet ist, dass mindestens ein organisches Material enthält.

Bevorzugt sind das erste Substrat und das zweite Substrat relativ zueinander derart angeordnet, dass das optoelektronische Bauelement zwischen dem ersten Substrat und dem zweiten Substrat angeordnet ist.

Bei einer weiteren Ausführungsform ist zwischen dem ersten Substrat und dem zweiten Substrat ein Verbindungsmaterial angeordnet, welches das optoelektronische Bauelement rahmenförmig umschließt und erstes und zweites Substrat mechanisch miteinander verbindet.

Bei einer bevorzugten Weiterbildung wurde das Verbindungsmittel mittels eines exothermen chemischen Prozesses eines reaktionsfähigen Materials zum mechanischen Verbinden der Substrate erweicht.

Bei einer besonders bevorzugten Ausführungsform weist das Bauteil ein erstes Substrat und ein zweites Substrat auf, wobei auf dem ersten Substrat mindestens ein optoelektronisches Bauelement angeordnet ist. Ferner sind das erste Substrat und das zweite Substrat relativ zueinander derart angeordnet, dass das optoelektronische Bauelement zwischen dem ersten Substrat und dem zweiten Substrat angeordnet ist. Ein Verbindungsmaterial ist zwischen dem ersten Substrat und dem zweiten Substrat angeordnet, welches das optoelektronische Bauelement raumförmig umschließt und erstes und zweites Substrat mechanisch miteinander verbindet. Das Verbindungsmaterial wurde mittels eines exothermen chemischen Prozesses eines reaktionsfähigen Materials zum mechanischen Verbinden der Substrate erweicht.

Das optoelektronische Bauelement wird vorzugsweise vollständig von dem ersten Substrat, dem zweiten Substrat und dem Verbindungsmaterial eingeschlossen. Dabei bilden die zwei Substrate und das Verbindungsmaterial bevorzugt eine geschlossene Zelle, in der das optoelektronische Bauelement angeordnet ist. Die Zelle setzt sich dabei aus zwei Grundflächen, insbesondere dem ersten Substrat und dem zweiten Substrat, und Seitenflächen, insbesondere dem Verbindungsmaterial, zusammen, wobei die Seitenflächen die zwei Grundflächen miteinander verbinden.

Durch den Prozess des Erweichens mittels eines reaktionsfähigen Materials kann insbesondere das Verbindungsmaterial des fertigen Bauteils bereichsweise Rückstände des reaktionsfähigen Materials aufweisen. Unter Rückstände des reaktionsfähigen Materials werden dabei nicht nur Anteile des reaktionsfähigen Materials selbst verstanden, sondern auch Reaktionsprodukte, die während des exothermen Prozesses entstehen können.

Somit kann das zuvor erweichte und vorzugsweise anschließend ausgehärtete Verbindungsmaterial bereichsweise zusätzliche Bestandteile, insbesondere Rückstände, des reaktionsfähigen Materials und/oder seiner Reaktionsprodukte aufweisen.

Der Schutz des organischen optoelektronischen Bauelements vor Umwelteinflüssen erfolgt demnach durch das Verbindungsmaterial, das zwischen erstem und zweitem Substrat so erweicht wurde, dass das Verbindungsmaterial eine mechanische Verbindung zwischen dem ersten Substrat und dem zweiten Substrat darstellt.

Unter Umwelteinflüsse ist insbesondere das Eindringen von Luft und/oder Feuchtigkeit in das Bauteil zu verstehen. Das Eindringen von Luft oder Feuchtigkeit in das Bauteil würde zu einer Schädigung oder gar zu einer Zerstörung des optoelektronischen organischen Bauelements führen. Durch ein luftdichtes Verschließen des Bauteils kann mit Vorteil die Lebensdauer des Bauteils signifikant erhöht werden.

Der luftdichte Abschluss erfolgt vorzugsweise mittels eines reaktionsfähigen Materials. Dazu wurde mittels eines exothermen chemischen Prozesses des reaktionsfähigen Materials das Verbindungsmaterial temporär erweicht und anschließend mittels Erkalten ausgehärtet.

Zum Start des exothermen chemischen Prozesses des reaktionsfähigen Materials findet bevorzugt eine Initialzündung, beispielsweise ein Funken oder ein Laserstrahl, Verwendung. Das reaktionsfähige Material reagiert nach der Initialzündung exotherm, vorzugsweise ohne Gasentwicklung, und gibt dabei große Mengen Energie ab, wodurch sich das reaktionsfähige Material aufheizt. Durch Wärmeübertragung erweicht das Verbindungsmaterial temporär zumindest im Umfeld des reaktionsfähigen Materials. Das heißt, die vom reaktionsfähigen Material freigesetzte Energie ist ausreichend, um das Verbindungsmaterial zu erweichen oder aufzuschmelzen.

Als reaktionsfähige Materialien sind somit alle Materialien oder Materialmischungen geeignet, die nach einer Initialzündung eine exotherme chemische Reaktion, vorzugsweise ohne Gasentwicklung und bevorzugt selbsttätig, durchlaufen. Geeignete Materialien und Materialmischungen sind beispielsweise in dem US-Patent US 2001/0046597 A1 beschrieben.

Bevorzugt weist das reaktionsfähige Material ein Element und ein Oxid oder eine Verbindung auf. Das reaktionsfähige Material reagiert dabei vorzugsweise über das Element, dass das Oxid oder die Verbindung mittels einer Reduktion umwandelt, sodass vorzugsweise ein stabileres Oxid oder eine stabilere Verbindung entsteht.

Als Element kann beispielsweise Al, Si, Ti, Zr oder Hf Verwendung finden. Dazu ist als Oxid oder Verbindung beispielsweise Fe₂O₃, CuO, ZnO oder NiB möglich. Als mögliche Endprodukte nach dem exothermen chemischen Prozess entstehen dabei ein Metall (Fe, Cu, Zn oder Ni) und ein weiteres Oxid oder eine weitere Verbindung (Al₂O₃, SiO₂, TiO₂, ZrO₂, HfO₂, TiB₂, ZrB₂ oder HfB₂).

Bereiche des Bauteils, die kein reaktionsfähiges Material aufweisen, erfahren dabei keine oder kaum eine Erhitzung. Die Gefahr einer Schädigung des organischen optoelektronischen Bauelements, die durch zu hohe Temperaturen in dem Bauteil herrührt, kann dadurch mit Vorteil minimiert werden.

Das reaktionsfähige Material ist direkt in das Verbindungsmaterial eingebracht und in dem Verbindungsmaterial homogen verteilt.

Durch in das Verbindungsmaterial eingebrachtes reaktionsfähiges Material kann nach einer Initialzündung das reaktionsfähige Material in dem Verbindungsmaterial reagieren. Dadurch, dass das reaktionsfähige Material exotherm reagiert, erwärmt sich bevorzugt das reaktionsfähige Material und bringt dadurch das umliegende Verbindungsmaterial zum Schmelzen.

Dadurch, dass das reaktionsfähige Material in das Verbindungsmaterial eingebracht ist, kann bevorzugt ein gleichmäßiges Erweichen des Verbindungsmaterials gewährleistet werden, wodurch mit Vorteil ein gleichmäßiger luftdichter Abschluss erfolgt.

Ferner breitet sich der exotherme chemische Prozess des reaktionsfähigen Materials vergleichsweise zu herkömmlichen Verfahren, wie beispielsweise das Heizen mittels eines umlaufenden Laserstrahls, sehr schnell über das gesamte Verbindungsmaterial aus. Die Herstellung des Bauteils in Massenproduktion ist dadurch mit Vorteil möglich.

Nach Abkühlen des Verbindungsmaterials und des reaktionsfähigen Materials bildet sich mit Vorteil eine bevorzugt hermetisch dichte Verbindung zwischen den zwei Substraten.

Bei einer bevorzugten Ausführungsform ist das erste Substrat und/oder das zweite Substrat jeweils ein Glassubstrat. Besonders bevorzugt enthalten das erste Substrat und/oder das zweite Substrat Fensterglas.

Unter Fensterglas ist insbesondere ein kalkhaltiges natriumhaltiges Glas zu verstehen, dass beispielsweise Kalziumcarbonat enthält. Weitere Carbonate und/oder Oxide sowie Verunreinigungen, können ferner im Fensterglas enthalten sein. Ein solches Glas ist auch bekannt als Kalk-Natron-Glas. Bei der Verbindungstechnik mittels eines exothermen chemischen Prozesses des reaktionsfähigen Materials kann dagegen mit Vorteil eine Erwärmung der Substrate oder eines der Substrate minimiert werden, da das Heizen des Verbindungsmaterials direkt im Verbindungsmaterial selbst stattfindet.

Bei einer bevorzugten Ausführungsform umfasst das Verbindungsmaterial eine Glasfritte. Unter dem Begriff Glasfritte versteht man ein Zwischenprodukt bei der Herstellung von Glasschmelzen. Die Glasfritte entsteht durch oberflächliches Schmelzen von Glaspulver, wobei die Glaskörner zusammen schmelzen. Die Glasfritte besteht aus einem porösen Material.

Bei einer weiteren Ausführungsform umfasst das Verbindungsmaterial ein Glaslot. Ein Glaslot zur Verkapselung eines Bauteils ist beispielsweise aus der Druckschrift US 6,936,963 B2 bekannt, deren Offenbarungsgehalt hiermit durch Rückbezug aufgenommen wird.

Bevorzugt erfolgt die elektrische Zuführung des organischen optoelektronischen Bauelements auf den dem optoelektronischen Bauelement zugewandten Oberflächen des ersten und/oder des zweiten Substrats. Das Verbindungsmaterial steht somit in direktem Kontakt mit der elektrischen Zuführung. Bevorzugt ist das Verbindungsmaterial zumindest in Bereichen, in denen sich die elektrische Zuführung des organischen optoelektronischen Bauelements befindet, elektrisch isolierend. Besonders bevorzugt ist das Verbindungsmaterial über den gesamten Bereich elektrisch isolierend.

Bevorzugt ist das optoelektronische Bauelement ein strahlungsemittierendes Bauelement, besonders bevorzugt eine organische lichtemittierende Diode (OLED). Das optoelektronische Bauelement kann ferner eine organische Fotodiode oder eine organische Solarzelle sein.

Ein Verfahren zum Herstellen eines Bauteils, das ein erstes Substrat, ein zweites Substrat, ein optoelektronisches Bauelement und ein Verbindungsmaterial aufweist, umfasst folgende Verfahrensschritte:
- Bereitstellen eines ersten Substrat, auf dem mindestens ein optoelektronisches Bauelement angeordnet ist, dass mindestens ein organisches Material enthält,
- Bereitstellen eines zweiten Substrats,
- Rahmenförmiges Anordnen eines Verbindungsmaterials auf dem ersten oder zweiten Substrat, wobei in dem Verbindungsmaterial ein reaktionsfähiges Material eingebracht wird
- Anordnen des ersten Substrats und des zweiten Substrats relativ zueinander derart, dass das optoelektronische Bauelement und das Verbindungsmaterial zwischen dem ersten Substrat und dem zweiten Substrat angeordnet sind, wobei das Verbindungsmaterial das optoelektronische Bauelement rahmenförmig umschließt, und
- Bereitstellen einer Initialzündung, die einen exothermen chemischen Prozess des reaktionsfähigen Materials auslöst.

Das Verbindungsmaterial kann dabei auf dem zweiten Substrat angeordnet werden. In diesem Fall werden anschließend das erste Substrat und das zweite Substrat relativ zueinander derart angeordnet, dass das Verbindungsmaterial das optoelektronische Bauelement rahmenförmig umschließt.

Alternativ kann das Verbindungsmaterial auf dem ersten Substrat angeordnet werden, wobei dabei das Verbindungsmaterial derart aufgebracht wird, dass das optoelektronische Bauelement rahmenförmig von dem Verbindungsmaterial umschlossen wird. Dabei wird das optoelektronische Bauelement vorzugsweise nach dem Verbindungsmaterial auf das erste Substrat aufgebracht. Anschließend wird in diesem Fall das zweite Substrat relativ zu dem ersten Substrat derart angeordnet, dass das optoelektronische Bauelement und das Verbindungsmaterial zwischen dem ersten und dem zweiten Substrat angeordnet werden.

Vorteilhafte Ausgestaltungen des Verfahrens ergeben sich analog zu den vorteilhaften Ausgestaltungen des Bauteils und umgekehrt. Mittels des Verfahrens ist insbesondere ein hier beschriebenes Bauteil herstellbar. Das bedeutet, die in Verbindung mit dem Bauteil offenbarten Merkmale sind auch für das Verfahren offenbart.

Durch ein derartiges Verfahren kann ein Bauteil hergestellt werden, dass ein organisches optoelektronisches Bauelement umfasst, wobei das organische optoelektronische Bauelement durch Verschließen des Bauteils gegen Umwelteinflüsse, wie beispielsweise Feuchtigkeit oder Luft, geschützt wird. Das Bauteil wird dabei so hergestellt, dass das organische optoelektronische Bauelement während der Herstellung keine thermische Belastung erfährt, die das organische optoelektronische Bauelement beschädigen oder gar zerstören könnte.

Das Verbindungsmaterial weist bevorzugt zum Aufbringen auf eines der Substrate eine pastöse Konsistenz auf, so dass das Verbindungsmaterial startend an einem Punkt, vorzugsweise ohne Unterbrechung, so aufgetragen werden kann, dass es einen geschlossenen Rahmen bildet. Nach dem Aufbringen des Verbindungsmaterials wird dieses vorzugsweise zusammen mit dem Substrat, auf das es aufgebracht ist, gesintert.

Alternativ weist das Verbindungsmaterial eine pulverartige Konsistenz auf und wird auf eines der Substrate aufgerieselt.

Bevorzugt wird mittels des chemischen Prozesses das Verbindungsmaterial temporär erwärmt, so dass das Verbindungsmaterial erweicht wird und das erste Substrat und das zweite Substrat mechanisch miteinander verbunden werden.

Bevorzugt breitet sich nach der Initialzündung der exotherme Prozess des reaktionsfähigen Materials selbsttätig aus. Die Initialzündung erfolgt vorzugsweise mittels eines Funkens oder eines Laserstrahls.

Dadurch, dass sich der exotherme Prozess nach der Initialzündung selbsttätig ausbreitet, ist es möglich, gleichzeitig eine Vielzahl von optoelektronischen Bauelementen, die gemeinsamen auf einem der Substrate angeordnet sind, zu verkapseln. Dabei können die optoelektronischen Bauelemente gemeinsam von dem Verbindungsmaterial umschlossen werden, oder jedes optoelektronische Bauelement wird einzeln rahmenförmig von dem Verbindungsmaterial umschlossen und bildet so ein eigenes Bauteil.

Dazu werden die einzelnen Verbindungsmaterialien der gemeinsam herzustellenden Bauteile geschickt aneinander gekettet, so dass nach Initialzündung eine Vielzahl von optoelektronischen Bauteilen gleichzeitig verkapselt wird, wobei die Bauteile anschließend vorzugsweise vereinzelt werden. Die Herstellung in Großserie der optoelektronischen Bauteile ermöglicht sich dadurch mit Vorteil.

Unter einem geschickten Aneinanderketten ist unter anderem zu verstehen, dass die einzelnen Verbindungsmaterialien der gemeinsam herzustellenden Bauteile ohne Unterbrechung aneinandergereiht werden, sodass sich nach Initialzündung der exotherme Prozess ohne Unterbrechung selbsttätig über die einzelnen Verbindungsmaterialien ausbreiten kann. Beispielsweise sind die einzelnen Verbindungsmaterialien jeweils rahmenförmig um ein oder mehrere Bauelemente angeordnet, wobei die einzelnen rahmenförmigen Verbindungsmaterialien jeweils über Verbindungslinien, die zumindest ebenfalls das reaktionsfähige Material aufweisen, miteinander verbunden sind.

Weitere Merkmale, Vorteile, bevorzugte Ausgestaltungen und Zweckmäßigkeiten des Bauteils ergeben sich aus den im Folgenden in Verbindung mit den Figuren 1 bis 4 erläuterten Ausführungsbeispielen. Es zeigen:
- Figur 1: eine schematische Aufsicht auf ein erstes Ausführungsbeispiels eines erfindungsgemäßen Bauteils,
- Figur 2: einen schematischen Querschnitt eines Ausführungsbeispiels aus Figur 1, welches nicht Teil dieser Erfindung ist.
- Figur 3a: einen schematischen Querschnitt eines zweiten Ausführungsbeispiels eines Bauteils, das nicht Teil dieser Erfindung ist, während des Verfahrensschrittes der Initialzündung,
- Figur 3b: einen schematischen Querschnitt eines dritten Ausführungsbeispiels eines Bauteils, das nicht Teil dieser Erfindung ist, während des Verfahrensschrittes der Initialzündung,
- Figur 3c: einen schematischen Querschnitt eines vierten Ausführungsbeispiels eines erfindungsgemäßen Bauteils während des Verfahrensschrittes der Initialzündung, und
- Figur 4: einen schematischen Querschnitt einer organischen lichtemittierenden Diode (OLED).

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

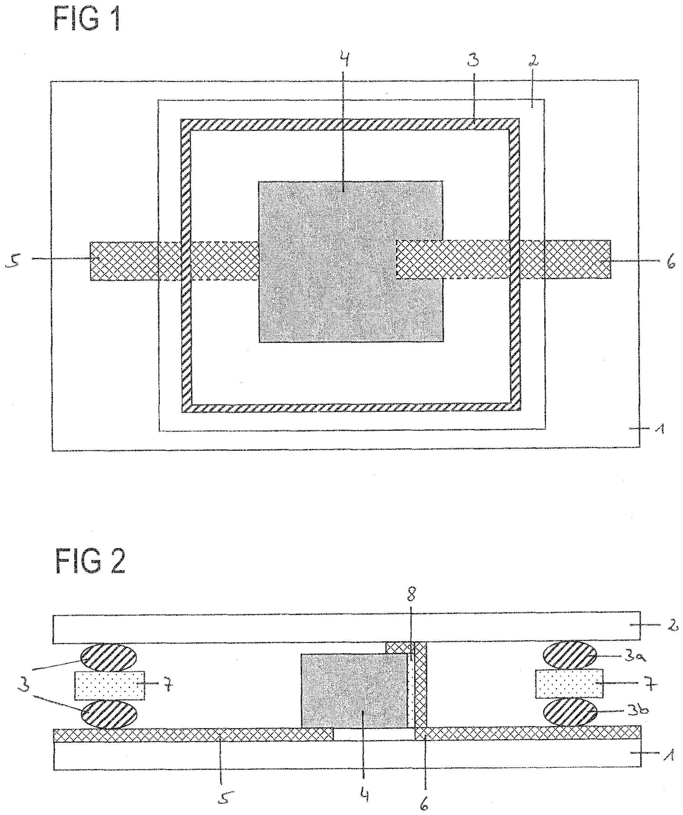

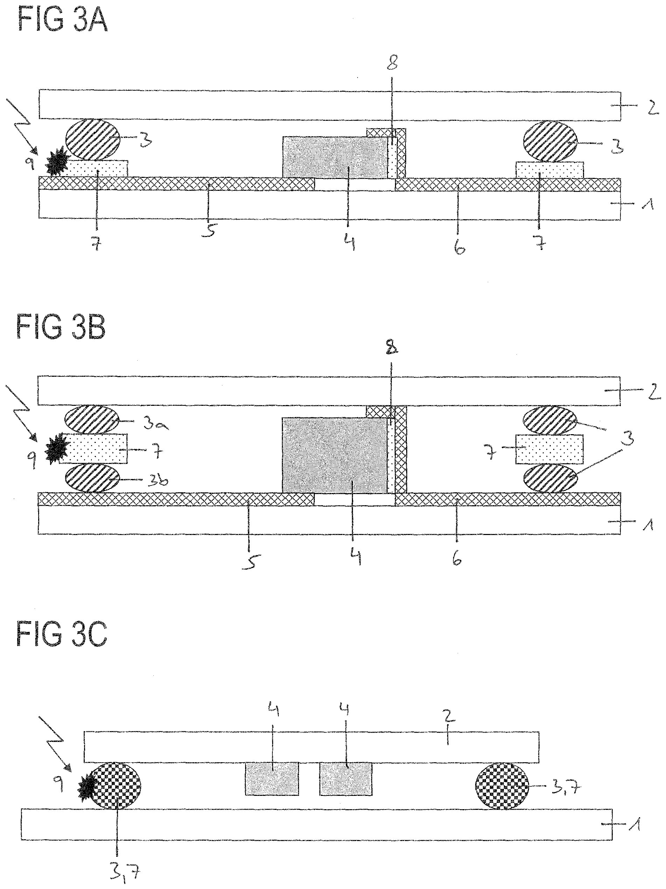

In den Figuren 1 bis 3 ist jeweils ein Bauteil dargestellt, dass ein erstes Substrat 1 und ein zweites Substrat 2 aufweist. Die Figuren 3a bis 3c stellen jeweils einen Verfahrensschritt zur Herstellung eines solchen Bauteils dar.

Figur 1 zeigt eine schematische Aufsicht auf ein Bauteil. Figur 2 stellt dazu einen schematischen Querschnitt des Bauteils aus Figur 1 dar. Das Bauteil weist ein erstes Substrat 1 und ein zweites Substrat 2 auf. Zwischen dem ersten Substrat 1 und dem zweiten Substrat 2 ist ein optoelektronisches Bauelement 4 angeordnet. Das optoelektronische Bauelement 4 enthält mindestens ein organisches Material.

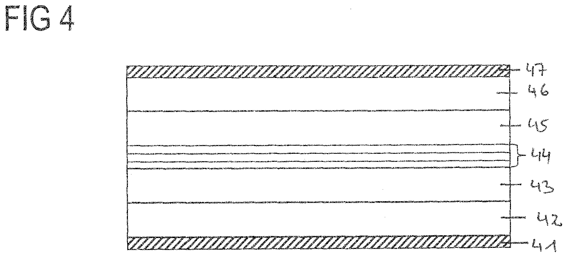

Bevorzugt ist das optoelektronische Bauelement 4 ein strahlungsemittierendes Bauelement, besonders bevorzugt eine organische lichtemittierende Diode (OLED). Eine OLED zeichnet sich dadurch aus, dass mindestens eine Schicht der OLED ein organisches Material umfasst. Eine OLED weist beispielsweise folgenden Aufbau auf, der unter anderem in Figur 4 dargestellt ist:
- Kathode 47,
- Elektronen induzierende Schicht 46,
- Elektronen leitende Schicht 45,
- emittierende Schichten 44,
- Löcher leitende Schicht 43,
- Löcher induzierende Schicht 42, und
- Anode 41.

Eine der Schichten, bevorzugt alle Schichten mit Ausnahme der Kathode und der Anode, umfasst ein organisches Material.

Das optoelektronische Bauelement 4 kann ferner eine Fotodiode oder eine Solarzelle sein, die mindestens ein organisches Material enthält.

Zwischen dem ersten Substrat 1 und dem zweiten Substrat 2 ist ein Verbindungsmaterial 3 angeordnet. Das Verbindungsmaterial 3 umschließt das optoelektronische Bauelement 4 rahmenförmig. Ferner verbindet das Verbindungsmaterial 3 das erste Substrat 1 und das zweite Substrat 2 mechanisch miteinander.

Das Verbindungsmaterial umschließt das optoelektronische Bauelement 4 vollständig. Dadurch schützt das Verbindungsmaterial 3 das optoelektronische Bauelement 4 vor Umwelteinflüssen. Unter Umwelteinflüssen ist insbesondere das Eindringen von Luft oder Feuchtigkeit in das Bauteil zu verstehen. Gerade bei optoelektronischen Bauelementen 4, die mindestens eine organische Schicht aufweisen, führt der Kontakt mit Luft oder Feuchtigkeit nachteilig zu einer Schädigung oder gar zu einer Zerstörung des optoelektronischen organischen Bauelements 4. Das wird durch das Verbindungsmaterial 3 mit Vorteil vermieden.

Das luftdichte Abschließen des Bauteils durch das Verbindungsmaterial 3 erhöht somit mit Vorteil die Lebensdauer des organischen optoelektronischen Bauelements signifikant. Bevorzugt überragt das erste Substrat 1 das zweite Substrat 2 in Draufsicht auf das zweite Substrat 2 lateral, wie in Figur 1 dargestellt. Das bedeutet, dass das erste Substrat 1 und das zweite Substrat 2 unterschiedliche Größen der Grundflächen aufweisen, wobei vorzugsweise das erste Substrat 1 eine größere Grundfläche aufweist als das zweite Substrat 2.

Die elektrische Zuführung 5, 6 des organischen optoelektronischen Bauelements 4, erfolgt bevorzugt auf der dem optoelektronischen Bauelement 4 zugewandten Oberfläche des ersten Substrats 1. Dabei wird eine der elektrischen Zuführungen 5, 6 von einem Kontakt des optoelektronischen Bauelements 4, dass sich auf der von dem ersten Substrat abgewandten Seite des optoelektronischen Bauelements 4 befindet, über eine Seitenfläche des optoelektronischen Bauelements 4 zu dem ersten Substrat 1 geführt. Die Führung entlang der Seitenfläche des optoelektronischen Bauelements 4 ist dabei von den Schichten des optoelektronischen Bauelements 4 durch eine elektrisch isolierende Schicht 8 elektrisch isoliert.

Dadurch, dass das erste Substrat 1 vorzugsweise eine größere Grundfläche aufweist als das zweite Substrat 2, kann die elektrische Zuführung 5, 6 des optoelektronischen Bauelements 4 aus dem Verbindungsmaterial 3 herausgeführt und dort elektrisch angeschlossen werden. Wie in Figur 1 dargestellt, ragt somit die elektrische Zuführung 5, 6 des optoelektronischen Bauelements 4 lateral über das zweite Substrat 2 hinaus, so dass ein problemlos erreichbarer elektrischer Anschluss der elektrischen Zuführung 5, 6 erfolgen kann.

Wie in Figur 2 dargestellt (nicht Teil dieser Erfindung) weist das Verbindungsmaterial 3 zwei Teilbereiche 3a, 3b auf. Zwischen den zwei Teilbereichen 3a, 3b ist ein reaktionsfähiges Material 7, das bevorzugt als Folie ausgebildet ist, angeordnet. Das reaktionsfähige Material 7 ist dabei so zwischen den Teilbereichen 3a, 3b des Verbindungsmaterials 3 angeordnet, dass das Verbindungsmaterial 3a, 3b an der Oberfläche und der Unterfläche des reaktionsfähigen Materials 7 anliegt.

Das luftdichte Abschließen des Bauteils erfolgt mittels eines exothermen chemischen Prozesses des reaktionsfähigen Materials 7. Dazu wird mittels der chemischen Reaktion das Verbindungsmaterial 3 temporär geschmolzen und anschließend mittels Erkalten ausgehärtet, so dass eine mechanische Verbindung zwischen erstem Substrat 1 und zweitem Substrat 2 entsteht.

Die exotherme chemische Reaktion startet bevorzugt mittels einer Initialzündung, die den exothermen chemischen Prozess des reaktionsfähigen Materials 7 auslöst. Durch den exothermen chemischen Prozess, der sich vorzugsweise selbsttätig ausbreitet, heizt sich das reaktionsfähige Material auf. Durch Wärmeübertragung erweicht dabei das Verbindungsmaterial 3a, 3b zumindest im Umfeld des reaktionsfähigen Materials 7.

Bereiche des Bauteils, die nicht im Umfeld des reaktionsfähigen Materials 7 angeordnet sind, erfahren dabei keine oder kaum eine Erhitzung. Die Gefahr einer Schädigung des organischen optoelektronischen Bauelements 4 während des Herstellungsprozesses des Bauteils kann dadurch mit Vorteil minimiert werden. Nach Beenden des exothermen chemischen Prozesses endet auch das Aufwärmen und Erhitzen des Verbindungsmaterials 3.

Das erste Substrat 1 und/oder das zweite Substrat 2 ist bevorzugt jeweils ein Glassubstrat. Besonders bevorzugt enthalten das erste Substrat 1 und/oder das zweite Substrat 2 Fensterglas.

Fensterglas stellt im Vergleich zu anderen Glasmaterialien, wie beispielsweise Borsilikatglas, ein kostengünstiges Material dar. Ein Bauteil, das ein erstes Substrat 1 und ein zweites Substrat 2 aus Fensterglas umfasst, ist somit mit Vorteil kostengünstig herstellbar.

Bevorzugt umfasst das Verbindungsmaterial 3 eine Glasfritte. Alternativ kann das Verbindungsmaterial 3 ein Glaslot umfassen.

Das reaktionsfähige Material 7 umfasst bevorzugt ein Material oder eine Materialmischung, dass die Eigenschaft aufweist, durch eine Initialzündung vorzugsweise ohne Gasentwicklung zu reagieren und dabei Energie abzugeben. Dadurch heizt sich das reaktionsfähige Material 7 auf, wodurch mit Vorteil das Verbindungsmaterial 3a, 3b, dass sich im Umfeld des reaktionsfähigen Materials 7 befindet, erweicht.

Das Verbindungsmaterial 3a, 3b steht in Bereichen der elektrischen Zuführung 5, 6 in direktem Kontakt mit der elektrischen Zuführung 5, 6. Zur Vermeidung eines Kurzschlusses, der durch das Verbindungsmaterial 3a, 3b vermittelt werden könnte, ist das Verbindungsmaterial 3a, 3b bevorzugt zumindest in Bereichen, in denen sich die elektrische Zuführung 5, 6 des organischen optoelektronischen Bauelements 4 befindet, elektrisch isolierend. Das Verbindungsmaterial 3a, 3b kann im gesamten Bereich elektrisch isolierend sein.

Bevorzugt steht das Verbindungsmaterial 3a, 3b nicht in direktem Kontakt mit dem organischen optoelektronischen Bauelement 4.

In den Figuren 3a (nicht Teil dieser Erfindung), 3b (nicht Teil dieser Erfindung) und 3c ist jeweils ein Beispiel des Verfahrensschrittes der Initialzündung dargestellt. Es erfolgt jeweils eine Initialzündung 9 mittels beispielsweise eines Funkens oder eines Laserblitzes, die die exotherme chemische Reaktion des reaktionsfähigen Materials 7 startet. Mittels der chemischen Reaktion heizt sich das reaktionsfähige Material 7 auf und erhitzt durch Wärmeübertragung so das Verbindungsmaterial 3 temporär, so dass das Verbindungsmaterial 3 erweicht wird und das erste Substrat 1 und das zweite Substrat 2 mechanisch miteinander verbunden werden.

Das Herstellungsverfahren ermöglicht dabei die Herstellung eines Bauteils, bei dem das organische optoelektronische Bauelement 4 während dem Herstellungsverfahren keine thermische Belastung erfährt, die das organische optoelektronische Bauelement 4 beschädigt oder gar zerstört. Ferner ist keine Führung eines Laserstrahls entlang des Verbindungsmaterials notwendig, wie es herkömmlicherweise der Fall ist. Der apparative Aufwand des Herstellungsverfahrens erniedrigt sich vergleichsweise so mit Vorteil.

In Figur 3a (nicht Teil dieser Erfindung) ist ein Bauteil dargestellt, bei dem das reaktionsfähige Material 7 als Folie zwischen dem Verbindungsmaterial 3 und dem ersten Substrat 1 angeordnet ist. Dabei steht das reaktionsfähige Material 7 in direktem Kontakt mit einer Oberfläche des Verbindungsmaterials 3, mit einer Oberfläche des ersten Substrats 1 und mit den darauf angeordneten elektrischen Zuführungen 5, 6.

Beispielsweise kann ein Verfahren zur Herstellung die im Folgenden genannten Verfahrensschritte aufweisen:
Auf ein zweites Substrat 2 wird rahmenförmig eine Glasfritte 3 aufgebracht, beispielsweise aufgerieselt, bevorzugt aufgesintert. Auf die Glasfritte 3, die beispielsweise als Pulver vorliegt, wird eine Folie gelegt, die ein reaktionsfähiges Material 7 aufweist. Ferner wird ein erstes Substrat 1 bereitgestellt, auf dem ein organisches optoelektronische Bauelement 4 aufgebracht ist.

Auf das zweite Substrat 2 wird nun das erste Substrat 1 gelegt. Das erste Substrat 1 wird so auf das zweite Substrat 2 gelegt, dass das organische optoelektronische Bauelement 4 zwischen erstem Substrat 1 und zweitem Substrat 2 angeordnet ist. Ferner werden das erste Substrat 1 und das zweite Substrat 2 so zueinander angeordnet, dass die Glasfritte 3 das organische optoelektronische Bauelement 4 rahmenförmig umschließt.

Bevorzugt wird auf dem ersten Substrat 1 ein Gewicht gelegt, das erstes und zweites Substrat 1, 2 gegeneinander drückt. Bevorzugt ist zwischen dem ersten Substrat 1 und dem zweiten Substrat 2 zumindest ein Abstandshalter, beispielsweise ein Lackring, angeordnet (nicht dargestellt).

Abstandshalter dienen dazu, gezielt einen festen Abstand zwischen erstem Substrat 1 und zweitem Substrat 2 festzulegen. Dadurch kann vermieden werden, dass während des Prozesses des Aufweichens des Verbindungsmaterials 3 die Substrate 1, 2 den durch die Abstandshalter festgelegten Abstand nicht unterschreitet, so dass die organischen optoelektronischen Bauelemente 4 während des Herstellungsverfahrens nicht durch einen zu geringen Abstand zwischen dem ersten Substrat 1 und dem zweiten Substrat 2 beschädigt werden.

Anschließend erfolgt die Initialzündung 9, beispielsweise mittels eines Funkens oder eines kurzen Laserblitzes. Durch die Initialzündung 9 startet eine exotherme chemische Reaktion des reaktionsfähigen Materials 7, das zwischen dem Verbindungsmaterial 3 und dem ersten Substrat 1 angeordnet ist. Nach der Initialzündung 9 breitet sich der exotherme Prozess des reaktionsfähigen Materials 7 bevorzugt selbsttätig entlang der Folie aus. Dadurch erwärmt sich die Folie mit darin enthaltenem reaktionsfähigem Material 7 und erweicht das Verbindungsmaterial 3 temporär.

Das erste und das zweite Substrat 1, 2 weisen bevorzugt eine hohe Wärmekapazität auf, so dass durch die hohe Wärmekapazität das geschmolzene Verbindungsmaterial 3 zeitnah erstarrt und eine hermetisch dichte Verbindung zwischen erstem Substrat 1 und zweitem Substrat 2 bildet.

Durch das hermetische Verkapseln mittels eines exothermen chemischen Prozesses können mit Vorteil gleichzeitig eine Vielzahl von organischen optoelektronischen Bauelementen 4 verkapselt werden (nicht dargestellt). Dazu wird das Verbindungsmaterial und das reaktionsfähige Material geschickt auf einem der Substrate aneinander gekettet, so dass nach Initialzündung zeitgleich eine Vielzahl von Zellen mit darin enthaltenem organischem optoelektronischen Bauelement verkapselt werden können.

In Figur 3b (nicht Teil dieser Erfindung) ist ein Bauteil dargestellt, bei dem das reaktionsfähige Material 7 als Folie zwischen zwei Teilbereichen 3a, 3b des Verbindungsmaterials 3 angeordnet ist. Dabei steht das reaktionsfähige Material 7 in direktem Kontakt mit zumindest jeweils einer Oberfläche eines Teilbereichs 3a, 3b des Verbindungsmaterials 3.

Ein Verfahren zur Herstellung eines in Figur 3b dargestellten Bauteils kann beispielsweise im Unterschied zu den Verfahrensschritten zur Herstellung des Bauteils aus Figur 3a die im Folgenden genannten Verfahrensschritte aufweisen:
Auf ein zweites Substrat 2 wird rahmenförmig eine erste Lage einer Glasfritte 3 aufgebracht, beispielsweise aufgerieselt, bevorzugt aufgesintert. Auf die erste Lage der Glasfritte 3, die beispielsweise als Pulver vorliegt, wird eine Folie gelegt, die ein reaktionsfähiges Material 7 aufweist. Ferner wird ein erstes Substrat 1 bereitgestellt, auf dem ein organisches optoelektronische Bauelement 4 aufgebracht ist.

Auf das erste Substrat 1 wird eine zweite Lage Glasfritte 3 aufgebracht, beispielsweise aufgerieselt, bevorzugt aufgesintert, wobei die zweite Lage Glasfritte 3 das organische optoelektronische Bauelement 4 rahmenförmig umgibt.

Alternativ kann auf das erste Substrat 1 zuerst eine zweite Lage Glasfritte 3 aufgesintert werden, und anschließend ein organisches optoelektronisches Bauelement 4 aufgebracht werden. Bei einem solchen Verfahren wird das organische optoelektronische Bauelement 4 vor einer Schädigung, die aufgrund hoher Temperaturen während des Prozesses des Sinterns entstehen können, geschützt.

Das Zusammenfügen des ersten und des zweiten Substrats erfolgt anschließend beispielsweise mit den Verfahrensschritten wie zu Figur 3a beschrieben.

Der in Figur 3c dargestellte Verfahrensschritt der Verkapselung unterscheidet sich von dem in den Figuren 3a und 3b dargestellten Verfahrensschritt dadurch, dass das reaktionsfähige Material 7 direkt in das Verbindungsmaterial 3 eingebracht ist. Das reaktionsfähige Material 7 ist homogen in dem Verbindungsmaterial 3 verteilt. Dadurch kann eine gleichmäßige Erwärmung des Verbindungsmaterials 3 erfolgen. Das reaktionsfähige Material 7 reagiert dabei nach Initialzündung 9 exotherm und breitet sich mit Vorteil selbsttätig aus, so dass eine vorzugsweise hermetisch dichte Verkapselung entsteht.

Ferner sind im Unterschied zu dem Bauteil aus Figur 3a und 3b zwischen dem ersten Substrat 1 und dem zweiten Substrat 2 mehrere organische optoelektronische Bauelemente 4 zwischen erstem Substrat 1 und zweitem Substrat 2 angeordnet. Das Bauteil ist demnach nicht auf die Verwendung lediglich eines optoelektronischen Bauelements 4 eingeschränkt. Die Anzahl der organischen optoelektronischen Bauelemente 4 kann in Hinsicht auf den Verwendungszweck des Bauteils variieren.

Diese Patentanmeldung beansprucht die Priorität der deutschen Patentanmeldung 10 2009 035 3925.

## Patentansprüche

1. Bauteil, das ein erstes Substrat (1) und ein zweites Substrat (2) aufweist, wobei
- auf dem ersten Substrat (1) mindestens ein optoelektronisches Bauelement (4) angeordnet ist, das mindestens ein organisches Material enthält,
- das erste Substrat (1) und das zweite Substrat (2) relativ zueinander derart angeordnet sind, dass das optoelektronische Bauelement (4) zwischen dem ersten Substrat (1) und dem zweiten Substrat (2) angeordnet ist,
- ein Verbindungsmaterial (3) zwischen dem ersten Substrat (1) und dem zweiten Substrat (2) angeordnet ist, welches das optoelektronische Bauelement (4) rahmenförmig umschließt und erstes und zweites Substrat (1, 2) mechanisch miteinander verbindet, und
- das Verbindungsmaterial (3) mittels eines exothermen chemischen Prozesses eines reaktionsfähigen Materials (7) zum mechanischen Verbinden der Substrate (1, 2) erweicht wurde,
**dadurch gekennzeichnet, dass**
das reaktionsfähige Material (7) direkt in das Verbindungsmaterial (3) eingebracht und in dem Verbindungsmaterial (3) homogen verteilt ist.

2. Bauteil gemäß Anspruch 1,
bei dem das optoelektronische Bauelement (4) vollständig von dem ersten Substrat (1), dem zweiten Substrat (2) und dem Verbindungsmaterial (3) eingeschlossen ist, wobei die zwei Substrate (1, 2) und das Verbindungsmaterial (3) eine geschlossene Zelle bilden, in der das optoelektronische Bauelement (4) angeordnet ist.

3. Bauteil gemäß einem der vorhergehenden Ansprüche,
bei dem das optoelektronische Bauelement (4) ein organisches optoelektronisches Bauelement (4) ist und eine elektrische Zuführung (5, 6) des organischen optoelektronischen Bauelements (4) auf den dem optoelektronischen Bauelement zugewandten Oberflächen des ersten und/oder des zweiten Substrats (1, 2) erfolgt, wobei das Verbindungsmaterial (3) in direktem Kontakt mit der elektrischen Zuführung (5, 6) steht.

4. Bauteil gemäß dem vorhergehenden Anspruch,
bei dem die elektrische Zuführung (5, 6) des organischen optoelektronischen Bauelements (4) auf der dem optoelektronischen Bauelement (4) zugewandten Oberfläche des ersten Substrats (1) erfolgt, wobei das erste Substrat (1) eine größere Grundfläche aufweist als das zweite Substrat (2), und wobei die elektrische Zuführung (5, 6) aus dem Verbindungsmaterial (3) herausgeführt und dort elektrisch anschließbar ist.

5. Bauteil gemäß dem vorhergehenden Anspruch,
bei dem die elektrische Zuführung (6) von einem Kontakt des optoelektronischen Bauelements (4), der sich auf einer von dem ersten Substrat (1) abgewandten Seite des optoelektronischen Bauelements (4) befindet, über eine Seitenfläche des optoelektronischen Bauelements (4) zu dem ersten Substrat (1) geführt ist, wobei die elektrische Zuführung (6) entlang der Seitenfläche des optoelektronischen Bauelements (4) von Schichten des optoelektronischen Bauelements (4) durch eine elektrisch isolierende Schicht (8) elektrisch isoliert ist.

6. Bauteil gemäß einem der vorhergehenden Ansprüche, wobei
das erste Substrat (1) und/oder das zweite Substrat (2) ein Glassubstrat ist.

7. Bauteil gemäß einem der vorhergehenden Ansprüche, wobei das Verbindungsmaterial (3) eine Glasfritte umfasst.

8. Bauteil gemäß einem der vorhergehenden Ansprüche, wobei das Verbindungsmaterial (3) ein Glaslot umfasst.

9. Bauteil gemäß einem der vorhergehenden Ansprüche, wobei das optoelektronische Bauelement (4) eine organische Licht emittierende Diode (OLED) ist.

10. Verfahren zum Herstellen eines Bauteils mit den Verfahrensschritten:
- Bereitstellen eines ersten Substrats (1), auf dem mindestens ein optoelektronisches Bauelement (4) angeordnet ist, das mindestens ein organisches Material enthält,
- Bereitstellen eines zweiten Substrats (2),
- rahmenförmiges Anordnen eines Verbindungsmaterials (3) auf dem ersten oder zweiten Substrat (1, 2), wobei in dem Verbindungsmaterial (3) ein reaktionsfähiges Material (7) eingebracht wird,
- Anordnen des ersten Substrats (1) und des zweiten Substrats (2) relativ zueinander derart, dass das optoelektronische Bauelement (4) und das Verbindungsmaterial (3) zwischen dem ersten Substrat (1) und dem zweiten Substrat (2) angeordnet ist, wobei das Verbindungsmaterial (3) das optoelektronische Bauelement (4) rahmenförmig umschließt, und
- Bereitstellen einer Initialzündung (9), die einen exothermen chemischen Prozess des reaktionsfähigen Materials (7) auslöst,
**dadurch gekennzeichnet, dass**
das reaktionsfähige Material (7) vor dem exothermen chemischen Prozess direkt in das Verbindungsmaterial (3) eingebracht und in dem Verbindungsmaterial (3) homogen verteilt wird.

11. Verfahren gemäß Anspruch 10, wobei ein Bauteil gemäß Anspruch 1 bis 9 hergestellt wird.

12. Verfahren gemäß einem der vorhergehenden Ansprüche 10 bis 11, wobei
das Verbindungsmaterial (3) zum Aufbringen auf eines der Substrate (1, 2) eine pastöse Konsistenz aufweist, sodass das Verbindungsmaterial (3) startend an einem Punkt ohne Unterbrechung derart aufgetragen wird, dass es einen geschlossenen Rahmen bildet.

13. Verfahren gemäß einem der vorhergehenden Ansprüche 10 bis 12, wobei
sich nach der Initialzündung (9) der exotherme Prozess des reaktionsfähigen Materials (7) selbsttätig ausbreitet.

14. Verfahren gemäß einem der vorhergehenden Ansprüche 10 bis 13, wobei
die Initialzündung (9) mittels eines Funken oder eines Laserblitzes erfolgt.

15. Verfahren gemäß einem der vorhergehenden Ansprüche 10 bis 14, wobei
mittels des chemischen Prozesses das Verbindungsmaterial (3) temporär erwärmt wird, sodass das Verbindungsmaterial (3) erweicht wird, und das erste Substrat (1) und das zweite Substrat (2) mechanisch miteinander verbunden werden.

## Claims

1. A device comprising a first substrate (1) and a second substrate (2), wherein
- at least one optoelectronic component (4) containing at least one organic material is arranged on the first substrate (1),
- the first substrate (1) and the second substrate (2) are arranged relative to each other in such a way that the optoelectronic component (4) is arranged between the first substrate (1) and the second substrate (2),
- a connecting material (3) is arranged between the first substrate (1) and the second substrate (2) which encloses the optoelectronic component (4) in a frame-like manner and mechanically connects the first and second substrates (1, 2) to one another, and
- the connecting material (3) had been softened by means of an exothermic chemical process of a reactive material (7) for mechanically bonding the substrates (1, 2),
**characterized in that**
the reactive material (7) is introduced directly into the connecting material (3) and is homogeneously distributed in the connecting material (3).

2. The device according to claim 1,
in which the optoelectronic component (4) is completely enclosed by the first substrate (1), the second substrate (2) and the connecting material (3), wherein the two substrates (1, 2) and the connecting material (3) form a closed cell in which the optoelectronic component (4) is arranged.

3. The device according to one of the previous claims,
in which the optoelectronic component (4) is an organic optoelectronic component (4) and an electrical connection (5, 6) of the organic optoelectronic component (4) takes place on the surfaces of the first and/or the second substrate (1, 2) facing the optoelectronic component, wherein the connecting material (3) is in direct contact with the electrical connection (5, 6).

4. The device according to the previous claim,
in which the electrical connection (5, 6) of the organic optoelectronic component (4) takes place on the surface of the first substrate (1) facing the optoelectronic component (4), wherein the first substrate (1) has a larger base area than the second substrate (2), and the electrical connection (5, 6) is guided out of the connecting material (3) and is electrically connectable there.

5. The device according to the previous claim,
in which the electrical connection (6) is guided from a contact of the optoelectronic component (4), which is located on the side of the optoelectronic component (4) remote from the first substrate (1), via a side surface of the optoelectronic component (4) to the first substrate (1), wherein along the side surface of the optoelectronic component (4), the electrical connection (6) is electrically insulated from layers of the optoelectronic component (4) by an electrically insulating layer (8).

6. The device according to one of the previous claims, wherein the first substrate (1) and/or the second substrate (2) is a glass substrate.

7. The device according to one of the previous claims, wherein the connecting material (3) comprises a glass frit.

8. The device according to one of the previous claims, wherein the connecting material (3) comprises a glass solder.

9. The device according to one of the previous claims, wherein the optoelectronic component (4) is an organic light emitting diode (OLED).

10. A method for producing a device comprising the process steps:
- providing a first substrate (1) on which at least one optoelectronic component (4) containing at least one organic material is arranged,
- providing a second substrate (2),
- arranging a connecting material (3) on the first or second substrate (1, 2) in a frame-like manner, wherein a reactive material (7) is introduced into the connecting material (3),
- arranging the first substrate (1) and the second substrate (2) relative to one another in such a way that the optoelectronic component (4) and the connecting material (3) are arranged between the first substrate (1) and the second substrate (2), wherein the connecting material (3) encloses the optoelectronic component (4) in a frame-like manner, and
- providing an initial ignition (9) which triggers an exothermic chemical process of the reactive material (7),
**characterized in that**
prior to the exothermic chemical process, the reactive material (7) is introduced directly into the connecting material (3) and is homogeneously distributed in the connecting material (3).

11. The method according to claim 10, wherein a device according to claim 1 to 9 is produced.

12. The method according to one of the previous claims 10 to 11, wherein
the connecting material (3) for being applied onto one of the substrates (1, 2) has a pasty consistency such that the connecting material (3) is applied from a starting point without interruption in such that it forms a closed frame.

13. The method according to one of the previous claims 10 to 12, wherein after the initial ignition (9), the exothermic process of the reactive material (7) automatically propagates.

14. The method according to one of the previous claims 10 to 13, wherein the initial ignition (9) is carried out by a spark or a laser flash.

15. The method according to one of the previous claims 10 to 14, wherein the connecting material (3) is temporarily heated by the chemical process so that the connecting material (3) is softened and the first substrate (1) and the second substrate (2) are mechanically bonded to each other.

## Revendications

1. Composant comprenant un premier substrat (1) et un second substrat (2), dans lequel
- au moins un élément optoélectronique (4) contenant au moins une matière organique est disposé sur le premier substrat (1),
- le premier substrat (1) et le second substrat (2) sont disposés l'un par rapport à l'autre de telle sorte que l'élément optoélectronique (4) est disposé entre le premier substrat (1) et le second substrat (2),
- un matériau de connexion (3), disposé entre le premier substrat (1) et le second substrat (2), encadre l'élément optoélectronique (4) et relie mécaniquement le premier et le second substrat (1, 2), et
- le matériau de connexion (3) a été ramolli au moyen d'un procédé chimique exothermique d'un matériau réactif (7) pour la liaison mécanique des substrats (1, 2),
**caractérisé en ce que**
le matériau réactif (7) est introduit directement dans le matériau de connexion (3) et est réparti de manière homogène dans le matériau de connexion (3).

2. Composant selon la revendication 1,
dans lequel l'élément optoélectronique (4) est complètement entouré par le premier substrat (1), le second substrat (2) et le matériau de connexion (3), les deux substrats (1, 2) et le matériau de connexion (3) formant une cellule fermée dans laquelle l'élément optoélectronique (4) est disposé.

3. Composant selon l'une des revendications précédentes,
dans lequel l'élément optoélectronique (4) est un élément optoélectronique organique (4) et
une alimentation électrique (5, 6) du élément optoélectronique organique (4) s'effectue sur les surfaces du premier et/ou du second substrat (1, 2) faisant face au élément optoélectronique, le matériau de connexion (3) étant en contact direct avec l'alimentation électrique (5, 6) .

4. Composant selon la revendication précédente,
dans lequel l'alimentation électrique (5, 6) du élément optoélectronique organique (4) s'effectue sur la surface du premier substrat (1) faisant face au élément optoélectronique (4), le premier substrat (1) présentant une surface de base plus grande que le second substrat (2) et l'alimentation électrique (5, 6) étant conduite hors du matériau de connexion (3) et pouvant y être électriquement raccordée.

5. Composant selon la revendication précédente,
dans lequel l'alimentation électrique (6) est guidée d'un contact du élément optoélectronique (4), situé sur une face du élément optoélectronique (4) éloignée du premier substrat (1), via une face latérale du élément optoélectronique (4) vers le premier substrat (1), l'alimentation électrique (6) le long de la surface latérale du élément optoélectronique (4) étant électriquement isolée des couches du élément optoélectronique (4) par une couche électro-isolante (8).

6. Composant selon l'une des revendications précédentes,
dans lequel
le premier substrat (1) et/ou le second substrat (2) est un substrat en verre.

7. Composant selon l'une des revendications précédentes,
dans lequel
le matériau de connexion (3) comprend une fritte de verre.

8. Composant selon l'une des revendications précédentes,
dans lequel
le matériau de connexion (3) comprend un verre de soudure.

9. Composant selon l'une des revendications précédentes,
dans lequel
l'élément optoélectronique (4) est une diode électroluminescente organique (OLED).

10. Procédé de fabrication d'un composant comprenant les étapes suivantes :
- mise à disposition d'un premier substrat (1) sur lequel est disposé au moins un élément optoélectronique (4) contenant au moins un matériau organique,
- mise à disposition d'un second substrat (2),
- agencement en forme de cadre d'un matériau de connexion (3) sur le premier ou le second substrat (1, 2), un matériau réactif (7) étant introduit dans le matériau de connexion (3),
- agencement du premier substrat (1) et du second substrat (2) l'un par rapport à l'autre de telle sorte que l'élément optoélectronique (4) et le matériau de connexion (3) soient disposés entre le premier substrat (1) et le second substrat (2), le matériau de connexion (3) encadrant l'élément optoélectronique (4), et
- mise à disposition d'un allumage initial (9) qui déclenche un processus chimique exothermique du matériau réactif (7),
**caractérisé en ce que**
le matériau réactif (7) est introduit directement dans le matériau de connexion (3) avant le processus chimique exothermique et est distribué de manière homogène dans le matériau de connexion (3).

11. Procédé selon la revendication 10, dans lequel un composant selon la revendication 1 à 9 est fabriqué.

12. Procédé selon l'une des revendications 10 à 11, dans lequel
le matériau de connexion (3) destiné à être appliqué sur l'un des substrats (1, 2) a une consistance pâteuse telle que le matériau de connexion (3) est appliqué à partir d'un point sans interruption, de manière à former un cadre fermé.

13. Procédé selon l'une des revendications 10 à 12, dans lequel
le processus exothermique du matériau réactif (7) se propage automatiquement après l'allumage initial (9).

14. Procédé selon l'une des revendications 10 à 13, dans lequel
l'allumage initial (9) est effectué au moyen d'une étincelle ou d'un flash laser.

15. Procédé selon l'une des revendications 10 à 14, dans lequel
le matériau de connexion (3) est chauffé temporairement par le procédé chimique, de sorte que le matériau de connexion (3) est ramolli, et le premier substrat (1) et le second substrat (2) sont reliés mécaniquement l'un à l'autre.
